(19)

Europäisches
Patentamt

European
Patent Office

Office européen
des brevets

(11) **EP 2 249 170 A1**

(12) **EUROPEAN PATENT APPLICATION**

(43) Date of publication:
**10.11.2010 Bulletin 2010/45**

(51) Int Cl.:
**G01R 27/20** (2006.01)     **G01R 31/02** (2006.01)

(21) Application number: **09159431.7**

(22) Date of filing: **05.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Megger Limited
Dover,
Kent CT17 9EN (GB)**

(72) Inventors:
• **Zurek, Stanislaw
Canterbury, Kent CT1 3JD (GB)**

• **Mynott, Stephen
Canterbury, Kent CT14 9XH (GB)**
• **Hammett, Daniel Scott
Ashford, Kent TN23 5WA (GB)**
• **Gosford, Owen Thurstan
Folkestone, Kent CT20 3ET (GB)**

(74) Representative: **Finnie, Peter John
Gill Jennings & Every LLP
Broadgate House
7 Eldon Street
London EC2M 7LH (GB)**

(54) **Double-clamp earth tester device**

(57)     A double-clamp earth tester device, having a voltage-inducing transformer (VT) (30), a current-sensing transformer (CT) (32), a voltage source adapted to supply a voltage across a primary winding (31) on the VT core (44) and a signal processing unit (35) adapted to measure a resultant signal output from a secondary winding (33) on the CT core (46), is susceptible to errors induced by electromagnetic interference between the cores (44, 46) of the two transformers. Previously, the effects of this interference have been mitigated by surrounding one or both cores (44, 46) with electromagnetic shielding (42). This had lead to devices having a bulky head portion and attendant difficulties in accessing sites having restricted access (52). These problems have been overcome by providing means to modify the signal output form the secondary winding (33). This may be achieved magnetically by nullifying the parasitic magnetic fields (66) at source in the core (46) of the current-sensing transformer, or electrically by the addition of a negative signal to the output signal prior to or during processing in the signal processing unit (35).

FIG. 8

EP 2 249 170 A1

**Description**

**Field of the Invention**

Electrical installations must be grounded or earthed because this is essential for the safety of equipment, users and operating personnel. The earthing is achieved by connecting a suitable conductor, the protective earth, to a soil-buried conductive element such as a rod, bar, pipe or pylon. The resistance of this earthing electrode must be sufficiently low in order to provide requisite electrical protection, i.e. to dissipate an expected fault current thereby to reduce the likelihood of dangerous voltages arising. National and international standards define such required levels of protection.

The condition of the earthing electrodes and the value of the resistance of earthing electrodes (in short referred to as "earth resistance") should be inspected periodically, and there are a number of ways in which this can be carried out.

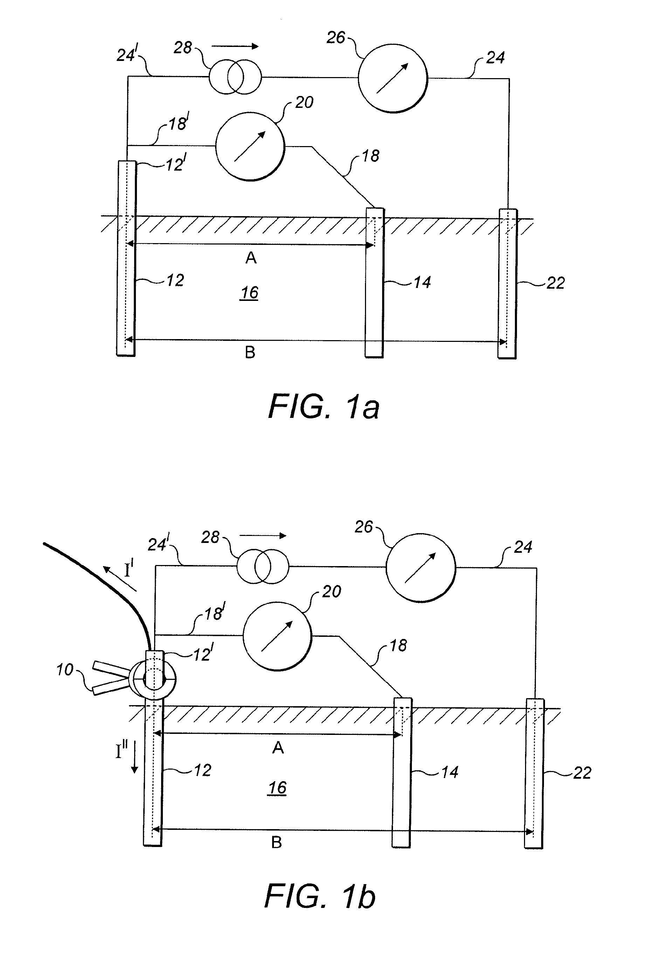

One technique, of which Fig. 1 a is an exemplary configuration, is known as the 3-pole fall-of-potential method. A connection is made to the accessible portion 12' of an earth electrode 12 under test. An auxiliary electrode 22 (the current stake) is driven into soil 16 at a distance B from the electrode under test and is connected to one terminal of an ammeter 26 by a connecting lead 24. The other terminal of the ammeter 26 is connected to one terminal of a current source 28 and the other terminal of the current source 28 is connected to the electrode under test 12 by a connecting lead 24'. A further auxiliary electrode 14 (the potential stake), which is driven into soil 16 a distance A from the electrode under test 12, is connected to one terminal of a voltmeter 20 by a connecting lead 18. The other terminal of the voltmeter 20 is connected to the electrode under test 12 by a connecting lead 18' in order to measure the potential difference between the auxiliary electrode 14 and the electrode under test 12.

A measurement of the resistance of the electrode under test is performed as follows:

The distance of the potential stake 14 to the electrode under test 12 is varied. At each distance, the current source 28 supplies a current I to the current stake 22 which is measured by the ammeter 26. The current returns through the soil 16 via the electrode under test 12. The potential difference between the voltage stake 14 and the electrode under test is measured by the voltmeter 20. The resistance of the electrode under test can be calculated from the ratio of the voltmeter 20 and ammeter 26 readings. A graph is plotted of resistance against distance A of the potential stake 14 and the true resistance of the electrode under test 12 can be determined from the graph by one skilled in the art.

This technique has several limitations:

a) If the electrode under test 12 is connected to other earthing electrodes or to equipment through which there is another electrical path to earth then a proportion I' of the injected current I will not be returned to the current source 28 and the value of resistance for the electrode under test 12 determined by the method will be lower than the actual resistance of the electrode under test 12.

b) If the electrode under test 12 is isolated from the equipment it is protecting so as to obtain a true measurement of its resistance, then that equipment and users of it will suffer from a reduced level of protection against the consequences of electrical faults.

A modification to the technique which counteracts these limitations is shown in Fig. 1b and is known as the 3-pole fall of potential with selective measurement. A current-sensing transformer 10 is clamped around an accessible portion 12' of the electrode under test 12 which measures the proportion I" of the injected current I which is returned via the electrode 12. This measured current I" is used in the calculation of resistance rather than I, i.e. I" = I - I'.

Such methods can be very time consuming, because they require manual insertion of the auxiliary metal electrodes 14; 22 into the soil 16 at least tens of meters away A, B from the electrode under test 12, with an attendant need for long leads 18; 24 to connect those metal electrodes with the electrode under test 12. Furthermore, such methods can pose a safety risk to the equipment being protected and to the users of that equipment if the electrode under test 12 is to be disconnected at any time and there are substantial leakage currents present.

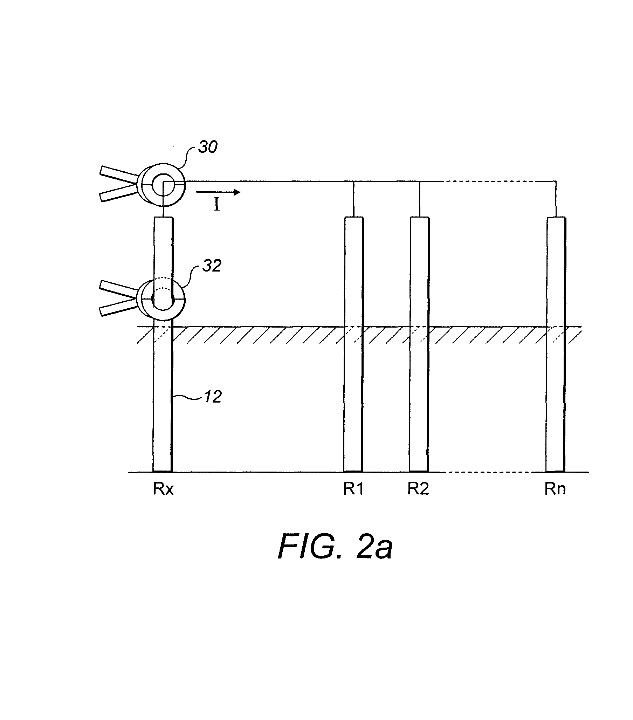

In order to overcome some of these problems, a technique was developed which allowed much faster and contactless earth resistance measurements. This well-known method employs a set of two transformers: a voltage inducing transformer and a current sensing transformer. A typical configuration is illustrated in Fig. 2a, which is described in greater detail below. Because the transformers are often made as clamps, the technique is often referred to as the 'double-clamp method', also known as the 'stakeless method'.

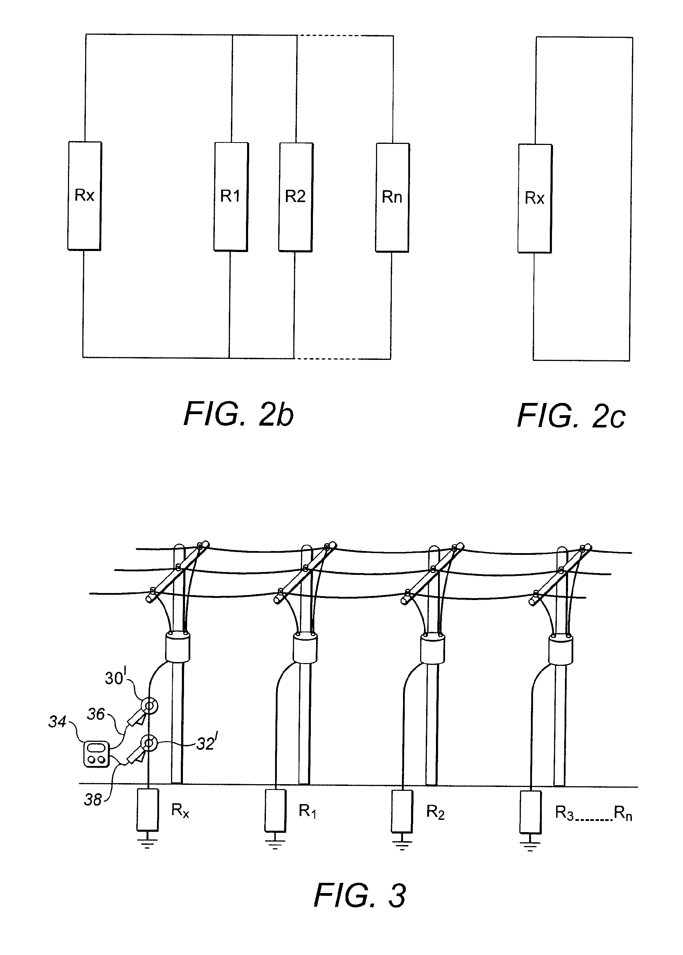

In an earthing system with multiple electrodes, as depicted schematically in the circuit diagram of Fig. 2b, the parallel resistance of all the electrodes (R1 ... Rn) tends to zero. Therefore, the resultant electric circuit simplifies to a loop with equivalent resistance Rx, whose value is very close to the resistance of the electrode under test. This is depicted schematically in the circuit diagram of Fig. 2c.

As shown in Fig. 2a, the loop is energised by the voltage-inducing transformer 30 (VT) and the current in the simplified loop is measured by the current-sensing transformer 32 (CT). Knowing the applied voltage and the current flowing in the equivalent loop it is possible to calculate the resistance Rx of the electrode under test 12 from Ohm's law.

The VT 30 includes a transformer core 44 and the CT 32 includes a transformer core 46.

This double-clamp method has a big advantage of performing the measurement without requiring any additional electrodes to be driven into the soil 16 and without disconnecting the rest of the earth system. In fact, the method relies on the rest of the system in order to achieve the simplification of the circuit from that of Fig. 2b to that of Fig. 2c and hence for the resistance calculated on the basis of the simplified loop of Fig. 2c to be valid.

Initially the two transformers 30, 32 used in the above-described double-clamp methods were made as separate clamps 30', 32', connected to a main unit 34 of the measuring device with suitable leads 36, 38, as shown in Fig. 3.

Such an approach was normal because the clamp-on transformers 30', 32' could also be used in other applications, such as the 3-pole fall of potential method discussed above and shown in Figs. 1a and 1b. However, this meant a non-optimum approach leading to large size and weight of the whole device.

Moreover, it has been found that the two clamps 30', 32' cannot be positioned too close to each other because of fundamental measurement inaccuracies induced by electromagnetic interference between the transformers, as set out in greater detail below.

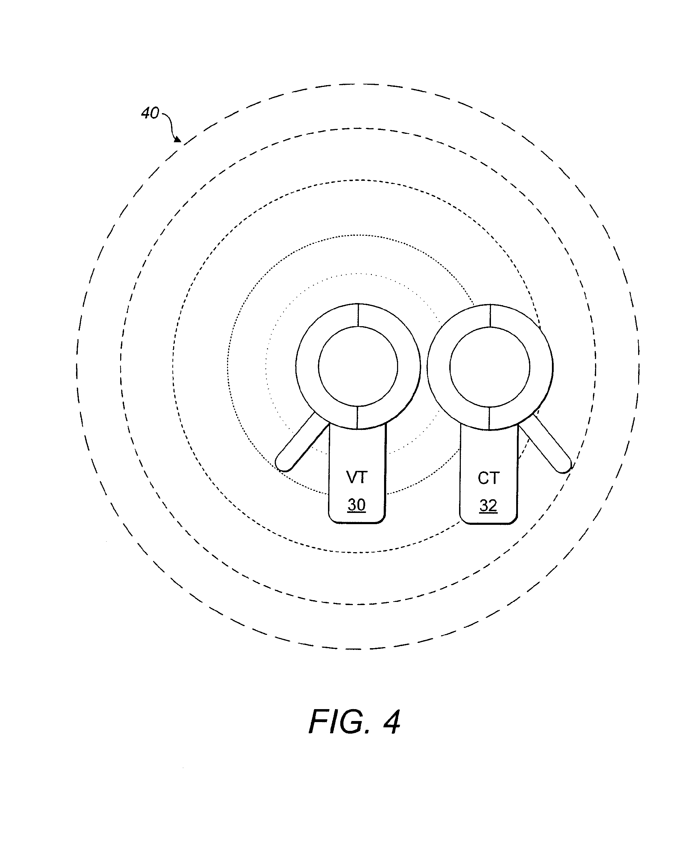

Fig. 4 schematically illustrates an electromagnetic field 40 that the VT 30 generates around itself. This field 40 induces the required voltage in the loop under test, with the induced current being measured by the CT 32. However, if the CT 32 is brought into the vicinity of the VT 30, then the surrounding electromagnetic field 40 interferes with the CT 32. This is known to adversely affect the measurement accuracy, due to unwanted signals parasitically induced in the CT 32 as a direct result of the electromagnetic field 40 emanating from the VT 30, in addition to the useful signals induced as a result of the voltage deliberately induced in the loop under test.

If the clamps 30', 32' of known double-clamp earth tester devices are used as two independent transformers they must be separated by some safe distance, which could be as much as 30 cm in order to obviate such parasitically induced unwanted signals. However, access to the electrode 12 to be tested is often very limited, so the user might be forced to operate the clamps 30', 32' much closer to each other than the optimal, interference-free distance. This inevitably leads to unreliable measurement results.

A number of double-clamp testers with an integrated head containing both transformers 30, 32 are currently on the market. These are provided as hand-held instruments. The integrated nature of these devices was an improvement over prior separate clamp designs as described above with reference to Fig. 3 in terms of operator ease-of-use and access to the electrode 12 to be tested.

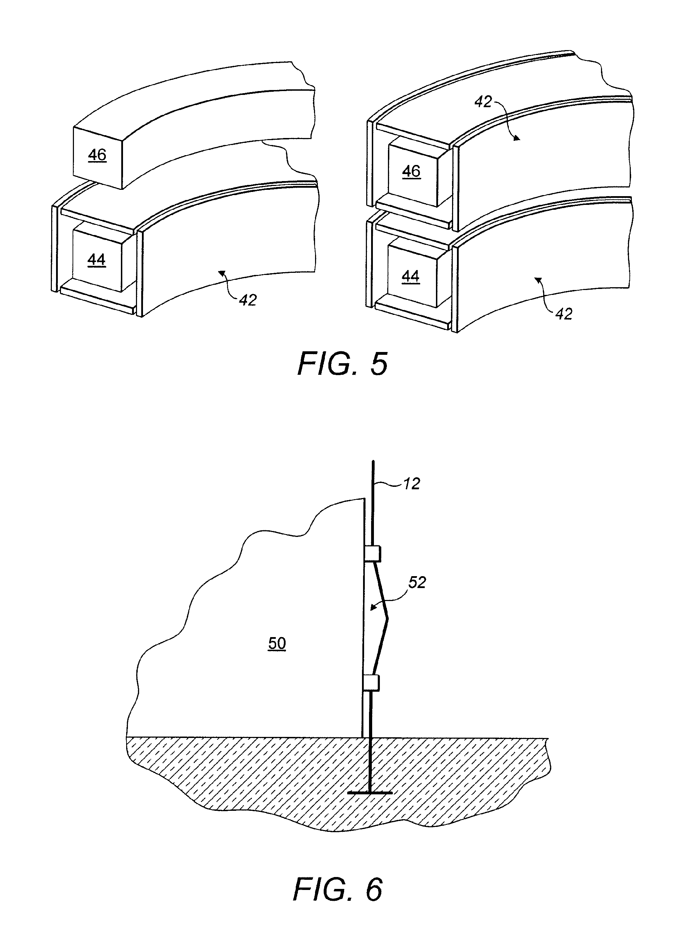

In order to reduce the electromagnetic interference effects described immediately above and to provide requisite measurement range and accuracy, such hand-held instruments with an integrated head use electromagnetic shielding 42 of one or both transformer cores 44, 46. Fig. 5 shows two most commonly used arrangements.

The shielding 42 is made out of ferromagnetic material, almost always with multiple layers. Because of the relatively high interference between the transformers 30, 32, a high quality (therefore expensive) shielding material 42 is required. In some double-clamp devices, up to 6 layers of shielding 42 are used between the two cores 44, 46. This significantly increases the cost of the device and still does not guarantee good accuracy at the high end of the measuring range; the maximum value measurable by such a shielded device is in the range 1250-1550 Ohms.

However, the relatively high cost of the measuring head is far less important than the bulkiness of the head. Earthing electrodes 12 are normally fixed to the surface of a building 50 or other structure, as illustrated schematically in Fig. 6, and there is generally very limited access 52 around the electrode 12 under test.

For that reason, the size and bulkiness of the head is absolutely critical for the usability of the device. The addition of electromagnetic shielding 42 surrounding at least one of the cores 44, 46 (but more often both of them) inevitably increases the overall size of the head considerably. An external casing (not shown) must also protect the whole device. Moreover, the shielding 42 must also be introduced to the inside of the core 44, 46 and this decreases the available inner diameter of the clamp 30, 32, thereby severely limiting the size of the conductor or electrode 12 that can be clamped around.

This bulkiness problem is widely recognised by the users. However, to date the equipment manufacturers have not been able to provide a device that overcomes this problem.

At the moment the only working solution is the expensive and bulky electromagnetic shielding 42 discussed above. There are some other concepts such as, for example, a single-core clamp as described in US 7,102,360 B2. Indeed, a single-core head without shielding would allow significant reduction in the head size. However, the associated measurement procedure involves not only extremely complicated mathematics (the description given in US 7,102,360 B2 contains over 40 equations), but also specialised electronic circuitry required for the calibration of the device. Moreover, as is apparent to those skilled in the art, the signal selectivity, sensitivity and accuracy of such a device would be inferior to that of a double-clamp device, even without the magnetic shielding.

There is therefore a need for a handheld portable device, which can be easily clamped around difficult to access electrodes. Such a device must be capable of repeatable and accurate resistance measurements over a wide operating range, and the construction of the instrument should be economical and compact in order to allow access in confined areas.

## Summary of the Invention

According to one aspect of the invention, there is provided a double-clamp earth tester device comprising:

a voltage-inducing transformer comprising a core and a primary winding having one or more turns around said voltage-inducing transformer core;

a current-sensing transformer comprising a core and a secondary winding having one or more turns around said current-sensing transformer core, wherein the voltage-inducing transformer core and the current-sensing transformer core are adapted to be clamped around an earth electrode under test;

a voltage source adapted to supply a voltage across the primary winding;

a signal processing unit adapted to measure a resultant signal output from the secondary winding; and

means to modify the signal output from the secondary winding so as to compensate for current induced by electromagnetic interference between the transformers.

The superior accuracy of the double-clamp method is retained, but without the need for the use of extensive electromagnetic shielding. The compensation technique permits construction of a much more compact head integrating both cores within close proximity to each other. The compensation technique can be conveniently applied in a variety of ways, depending on the specific requirements and limitations of the signal processing employed. The technique also substantially improves the accuracy of the resistance measurement over the whole range of the device.

In one embodiment the means to modify the signal output from the secondary winding comprises magnetic compensation means which is adapted to generate a magnetic field in the current-sensing transformer core that is equal but opposite in magnitude to the portion of a magnetic field induced in the current-sensing transformer core by the electromagnetic interference between the transformers.

This magnetic compensation technique nullifies at source the effects of the parasitic magnetic field that is induced in the current-sensing transformer core by the electromagnetic interference from the voltage-inducing transformer core. In other words, the signal output from the secondary winding is based solely upon the magnetic field induced in the current-sensing transformer core by the current flowing in the electrode under test.

The magnetic compensation means may comprise an additional winding around the current-sensing transformer core and an associated additional signal source. The additional signal source may be part of the signal processing unit.

The magnetic compensation means may alternatively comprise an auxiliary loop as a signal source around the voltage-inducing transformer core and the current-sensing transformer core. The electrode under test may comprise part of an earthing system that can be represented by a loop of equivalent resistance and the auxiliary loop may have reversed polarity with respect to the loop of equivalent resistance. The auxiliary loop may contain a configurable impedance $Z_{aux}$.

In another embodiment, the means to modify the signal output from the secondary winding comprises electric compensation means which is adapted to generate a compensating signal that is equal but opposite in magnitude to the portion of the signal output from the secondary winding induced by the electromagnetic interference between the transformers.

This electric compensation technique functions by nullifying the portion of the output signal that is induced as a result of the parasitic magnetic field that is induced in the current-sensing transformer core by the electromagnetic interference from the voltage-inducing transformer core. In other words, the signal output from the secondary winding is notionally based upon a combination of a magnetic field induced in the current-sensing transformer core by the current flowing in the electrode under test and a parasitic magnetic field that is induced directly by electromagnetic interference from the voltage-inducing transformer core. In effect, the electric compensation means introduces a negative signal that nullifies the portion of the output signal that results from the electromagnetic interference. Thus, the actual output signal that is received at the signal processing unit does not include that portion that results from the electromagnetic interference.

The electric compensation means may comprise a signal source to supply the compensating signal to the secondary winding. The signal source may comprise an auxiliary channel of the signal processing unit. The signal source may be tapped from the primary winding. This tapping may be achieved by means of a bridge circuit. The electrode under test may comprise part of an earthing system that can be represented by a loop of equivalent resistance and the signal source may comprise a parasitic winding around the voltage-inducing transformer core, which parasitic winding may have reversed polarity with respect to the loop of equivalent resistance. The parasitic winding may contain a configurable impedance $Z_{aux}$.

In another embodiment, the electric compensation means comprises an analogue-to-digital converter for digitizing the signal output from the secondary winding, and means to apply an algorithm to the digitized signal.

An advantage of this approach is that the compensation can be carried out by the implementation of appropriate software, rather than physical components.

Typically, the voltage source comprises part of the signal processing unit.

In yet another embodiment, the voltage-inducing transformer core and the current-sensing transformer core are integrated into a head portion of the device.

The compensation techniques of the invention have particular benefit by enabling the transformer cores to be located closer together than would otherwise be possible, yet retaining or improving accuracy of the device.

**Brief Description of the Drawings**

The invention will be described, by way of example, with reference to the accompanying drawings, in which:

Fig. 1a is a schematic illustration of an exemplary known configuration for 3-pole fall of potential earth electrode testing;
Fig. 1b corresponds to Fig. 1a, but shows a modified configuration for 3-pole fall of potential with selective measurement earth electrode testing;
Fig. 2 is representative of the known two-clamp method, with Fig. 2a being a schematic illustration of the physical configuration; Fig. 2b being a schematic diagram of a corresponding resistance network; and Fig. 2c being the equivalent resistance loop;
Fig. 3 illustrates schematically a typical use of the two-clamp method, using two separate clamps;
Fig. 4 is a schematic illustration of electromagnetic interference generated by the VT affecting the CT;
Fig. 5 is a simplified view of part of a double-clamp head, with electromagnetic shielding - the left-hand side showing shielding on just the lower core, the righthand side showing shielding on both cores;
Fig. 6 illustrates a typical earth electrode installation, having limited access for testing;
Fig. 7 is a schematic diagram of a typical double-clamp device;
Fig. 8 is a schematic diagram of a double-clamp device having magnetic compensation means according to the invention;
Fig. 9 corresponds to Fig. 8, but shows a device having parasitic magnetic compensation;
Fig. 10 corresponds to Fig. 8, but shows a device having output signal compensation;
Figs. 11 a to 11c correspond to Fig. 10, but show a device having output signal compensation 'tapped' from the VT supply;
Fig. 12 corresponds to Fig. 10, but shows a device having output signal compensation by means of a parasitic loop;
Fig. 13 is a graph illustrating typical results obtained with any of the compensation techniques according to the invention;
Fig. 14a is a schematic diagram of a double-clamp earth tester device having an integrated head portion; and
Fig. 14b is a schematic diagram of a double-clamp earth tester device having an alternative, differently shaped integrated head portion.

**Detailed description**

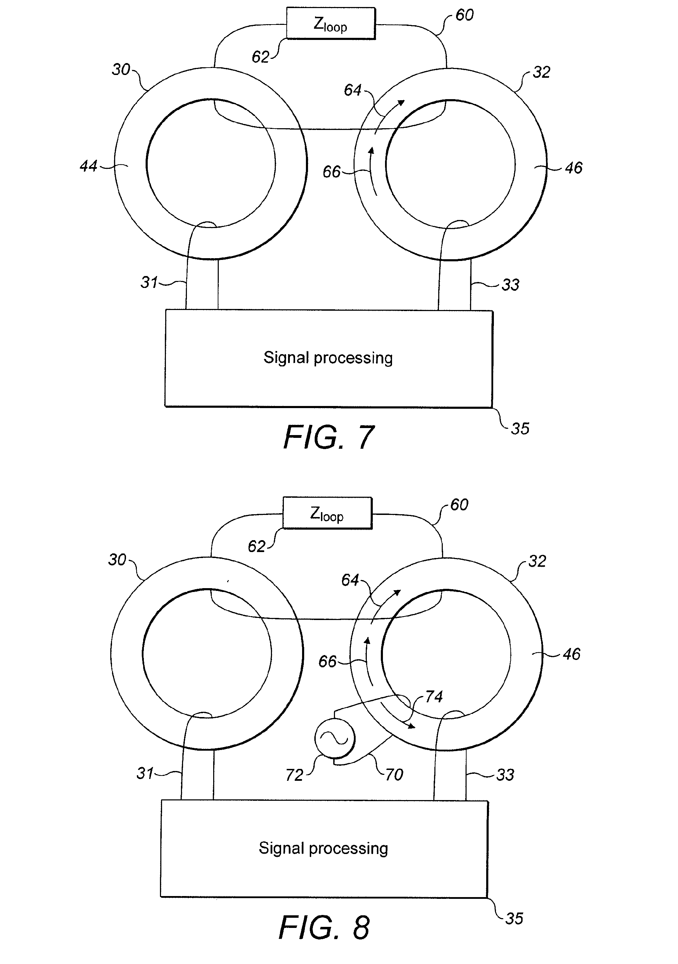

A typical double-clamp device is shown schematically in Fig. 7. The double-clamp device consists typically of a voltage-inducing transformer (VT) 30 with one or more turns of a primary winding 31 and a current-sensing transformer (CT) 32 which has a secondary winding 33 with one or more turns.

In use, both transformers 30, 32 clamp around an electrode under test, which is represented by the loop 60 of equivalent resistance having certain impedance $Z_{loop}$ 62, as discussed above by reference to Fig. 2. The voltage-inducing transformer core 44 and the current-sensing transformer core 46 are typically integrated into a head portion of the device.

A signal processing unit 35 supplies voltage to the VT 30. The voltage supplied through the primary winding 31 induces an electromagnetic field in the VT core 44, which in turn induces a current to flow in the loop 60. That current flowing in the loop 60 induces a desired magnetic field $H_{loop}$ 64 in the CT core 46. However, an unwanted magnetic field $H_{noise}$ 66 is also induced directly as a result of electromagnetic interference emanating from the VT 30, as discussed above by reference to Fig. 4.

The magnetic fields 64, 66 induced in the CT core 46 induce a current to flow in the secondary winding 33. A resultant output signal is received and measured at the signal processing unit 35. From that output signal, the value of the loop impedance 62 can be calculated.

The calculation utilises the equation (i):

$$(i) \qquad Z_{loop} = C_{calibration} \frac{V_{VT}}{f(H_{CT})}$$

where:

$C_{calibration}$ = calibration constant;
$V_{VT}$ = voltage across the primary coil 31 of the VT 30 proportional to the voltage induced in the loop 60;
$f$ = function relating magnetic field in the core 46 set up by the
primary current of the CT 32, and the output signal of the CT 32; and $f(H_{CT})$ = value of the output signal of the CT 32 related to the magnetic field $H_{CT}$ caused by the current in the loop 60 to be measured.

The value calculated from equation (i) is the modulus of the loop impedance 62. However, under normal circumstances the resistive component is prevailing. Thus, in practice, the measured value is often synonymous with resistance. However, if the non-resistive component is significant the method can be used also for impedance measurements.

The magnetic field $H_{CT}$ comprises a combination of the magnetic field $H_{loop}$ 64 generated by the current in the loop 60 as well as the magnetic field $H_{noise}$ 66 generated by the electromagnetic interference between the transformers 30, 32.

$$(ii) \qquad \overrightarrow{H}_{CT} = \overrightarrow{H}_{loop} + \overrightarrow{H}_{noise}$$

Therefore, the output signal of the CT 32, which equates to $f(H_{CT})$ is affected by the interference.

It is envisaged that a voltage source separate from the signal processing unit 35 could instead be used to supply the voltage to the VT. However, the supplied voltage should be known in order to calculate the loop impedance 62. Hence, the signal processing unit 35 must be in communication with such a separate voltage source, if such a separate voltage source were to be used.

This invention describes in detail methods for convenient removal of the unwanted part of the output signal $f(H_{CT})$. This can be achieved either by suppressing the magnetic component $H_{noise}$ 66 thus preventing any influence to the output signal of the CT 32, or by modifying the output signal of the CT 32 in order to correct for the unwanted signal already induced by the $H_{noise}$ 66. In the first approach, the compensation is achieved magnetically and thus comprises an indirect means to modify the output signal; in the latter, the compensation is achieved by appropriate analogue or digital signal processing and thus comprises a direct means to modify the output signal.

Magnetic compensation

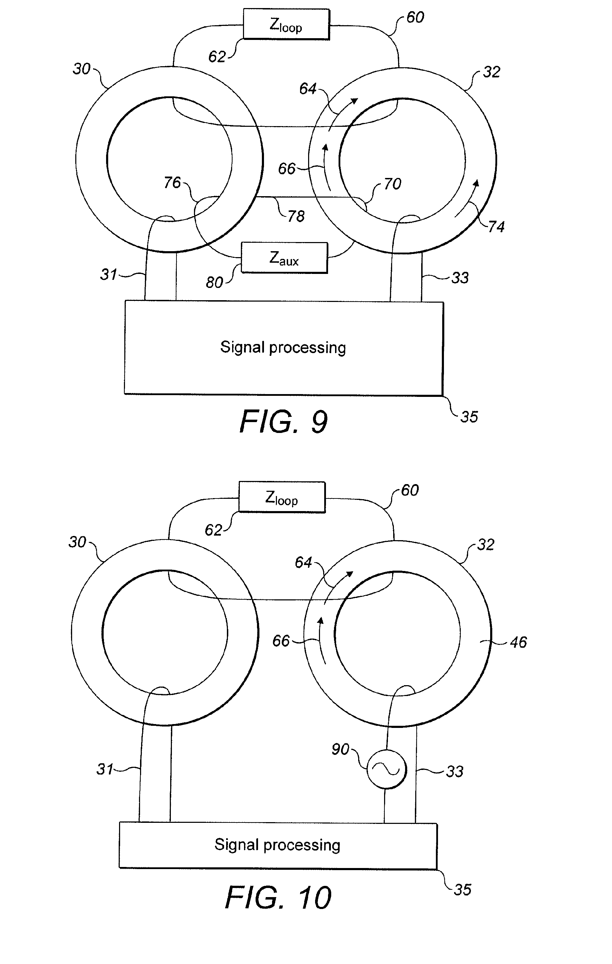

By reference to Figs. 8 and 9, in the magnetic compensation technique, the CT 32 is equipped with an auxiliary winding 70 having one or more turns. The auxiliary winding 70 is supplied with an appropriate signal that induces a current in the auxiliary winding 70 which in turn generates a magnetic field 74 in the CT core 46. The magnetic field 74 is equal but opposite in magnitude to the interference field 66. This suppresses the influence of electromagnetic interference to negligible values. The amplitude of the output signal across the secondary winding 33 is therefore free from any unwanted signals caused by the interference, so it can be directly measured by the signal processing unit 35. By reference to equation (ii), the $H_{noise}$ component 66 is removed, leaving $H_{CT} = H_{loop}$; and since the loop current can be found from $H_{CT}$ (refer to equation (i)), the measurement of the loop current can be accurate.

The compensating signal can be generated in a number of suitable ways. This can be achieved actively, as shown in Fig. 8, by driving the winding 70 from an additional signal generator, which could be a part of signal processing unit 35 or a separate element 72.

Alternatively, as shown in Fig. 9, the signal can be generated parasitically by using a second auxiliary winding 76 with one or more turns wrapped around the VT 30, thus forming an auxiliary loop 78 comprising the winding 70 around the CT 32 and the auxiliary winding 76. The auxiliary winding 76 can have a reversed polarity with respect to the loop 60. The auxiliary loop 78 can contain configurable impedance $Z_{aux}$ 80, whose role it is to adjust the amplitude and phase of the compensating signal.

It is also possible for the auxiliary winding 76 to have reversed polarity with respect to the primary winding 31.

Electric compensation

The interfering magnetic field 66 does not have to be suppressed magnetically in order to achieve the compensation. Where the output signal of the CT 32 consists of unwanted as well as useful signal components, electric compensation means can be provided to act on the output signal to nullify the unwanted signal components. The unwanted magnetic field $H_{noise}$ 66 remains present in the core 46, and only the electric signal induced in the winding 33 is compensated. As shown in Fig. 10, a suitably controlled signal source 90 can be inserted in series with the secondary CT winding 33. The amplitude and phase of the signal source 90 can be then adjusted in order to oppose the unwanted component of the output signal, induced due to the interfering magnetic field 66.

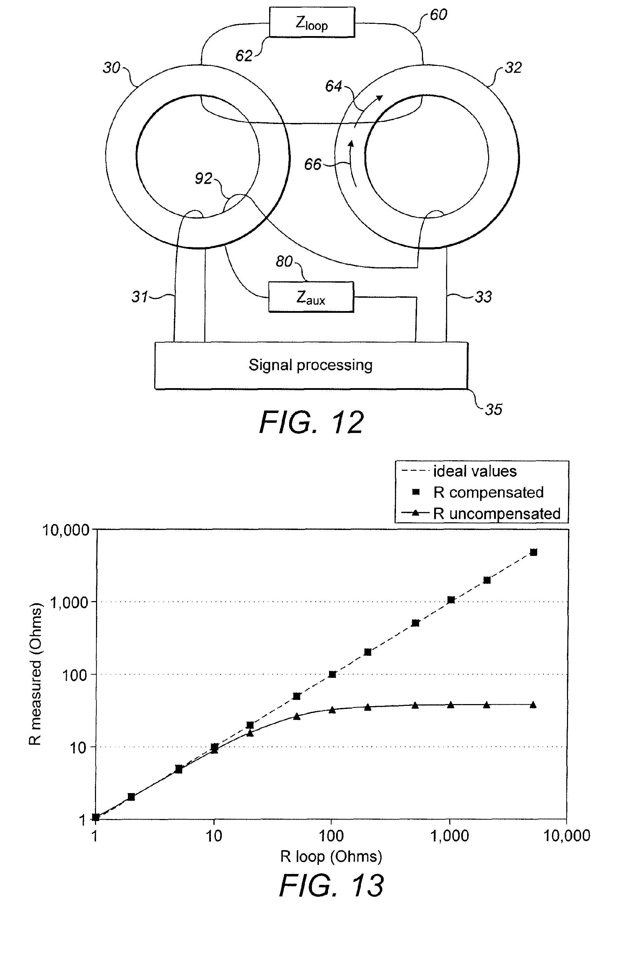

As in the magnetic compensation techniques, the compensating signal can be supplied either by an auxiliary channel of the signal processing unit 35 or by a parasitic winding 92 around the VT 30 (as in Fig. 12) or by any other signal generator. The parasitic winding 92 may be of reversed polarity with respect to the loop 60 of equivalent resistance, and/or with respect to the primary winding 31.

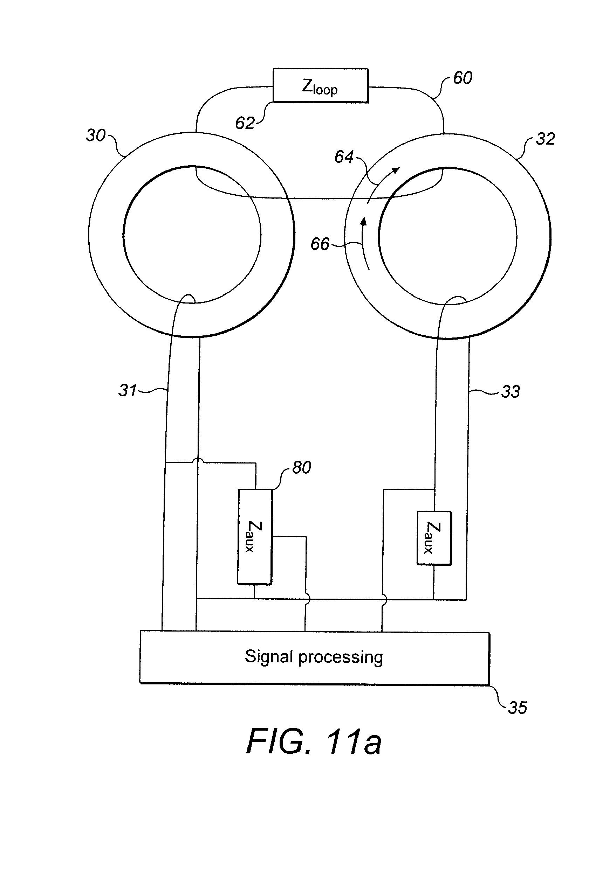

Another option is for the compensating signal to be tapped from the supply to the primary winding 31, so as to be driven by the same signals. Optional arrangements for tapping the compensating signal from the primary winding are illustrated in Figs. 11a-11c. In essence, these may be special instances of the arrangements of Fig. 8 or Fig. 10, with the signal sources 72 and 90 comprising the signals tapped from the primary winding 31.

Similarly to the auxiliary loop 78 of Fig. 9, suitable auxiliary impedance 80 can be used for amplitude and phase adjustment in these 'tapping' arrangements also.

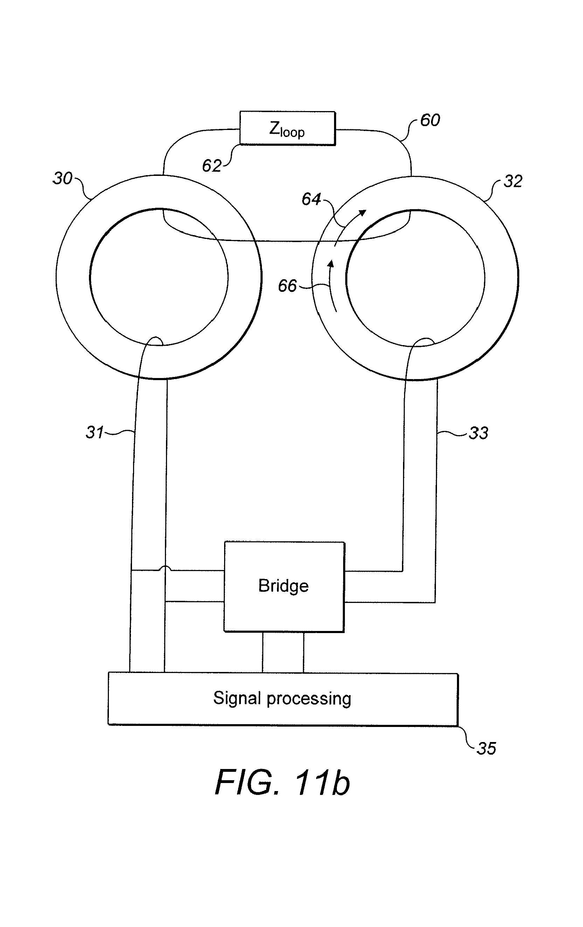

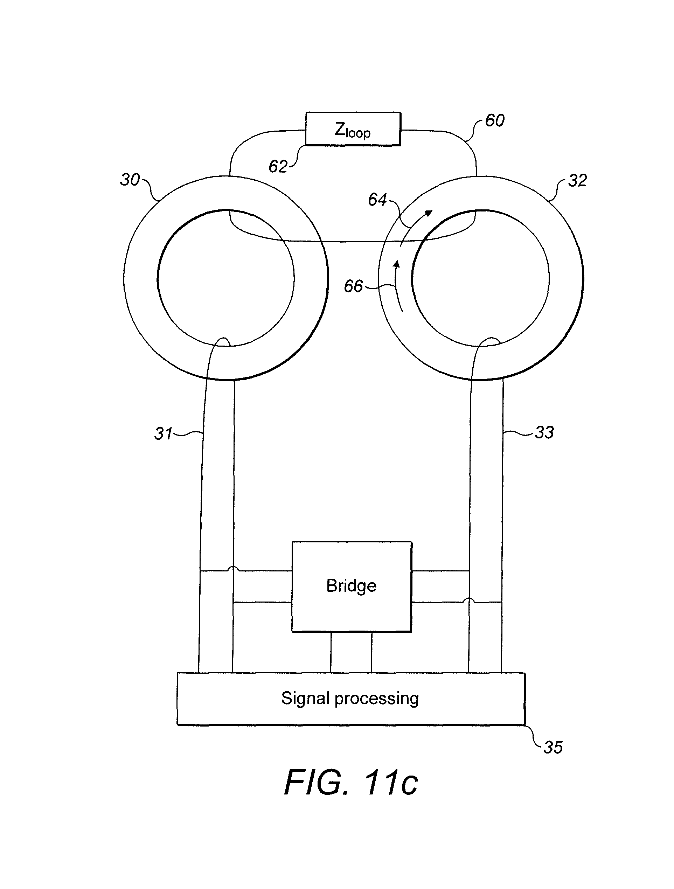

Another configuration for tapping the primary winding 31 is a bridge circuit, for example having connections as shown in Fig. 11a. The impedance 80 in the configuration of Fig. 11 a can be varied in a number of ways (RR, RC, CR, LR circuits, etc). Figs. 11b and 11c show more generic configurations in which the circuit designated "bridge" can be any combination, or a "network", of various interconnected elements, both passive (RLC) and active. As will be appreciated by the skilled reader, there are numerous combinations of possible connections of tapping, elements, auxiliary coil on CT and the output signal. Other types of "bridge network", such as an impedance network, differential amplifier, analogue comparator, differential measurement, etc.) are also possible.

By tapping the signal from the primary winding 31, an additional signal generator 72; 90 is not required. Alternatively, with respect to the configuration of Fig.12, no extra coil 92 is needed. As a result, the size and cost of the device can be reduced even further.

Software compensation

If the resolution, dynamic range and measurement accuracy of the signal processing unit 35 permit, the signal compensation shown in Fig. 10 can be achieved entirely by an appropriate digital algorithm (software), which may be implemented as firmware within the apparatus. The output signal across the secondary winding 33 can be digitised by an appropriate analogue-to-digital converter (not shown). Such a signal will then contain two components: the useful signal generated by the magnetic field 64 as well as the unwanted signal component generated by the interfering magnetic field 66.

The signal processing unit 35 may comprise separate sub-units for the digitising and the processing. For example, the digital compensation may be made before the compensated output signal is passed to a CPU in the signal processing unit 35 for resistance calculation.

A suitable set of data representing a waveform of required amplitude and phase can be represented in the software. Values of such data can be adjusted so as to represent a signal equal, but with opposing phase, to the unwanted component of the signal induced by the interfering magnetic field 66. Therefore, the equation employed for calculation of the measured loop impedance 62 will be modified from (i) and will take the following form:

$$\text{(iii)} \quad Z_{loop} = C_{calibration} \frac{V_{VT}}{f(H_{CT}) - S_{compensation}}$$

where:

$S_{compensation}$ = the data representing the unwanted component of the output signal of the CT 30.

The $S_{compensation}$ can take a form of a set of data (synonymous with a digital waveform containing the amplitude and phase information), as well as a single value (synonymous with a digital waveform containing only the amplitude information). The former method allows full compensation to be achieved, whereas the latter technique gives only partial compensation, but is much simpler to implement. In addition, and as described later, this equation has more general applicability in that it in essence describes each of the different compensation techniques, digital or otherwise.

In order to achieve the in-software compensation the following typical algorithms could be implemented.

*Main algorithm A:*

> *Step A1: Introduce the main loop with some impedance.*
> *Step A2: Measure VT and CT signals.*
> *Step A3: Subtract the digital compensation signal (waveform or value) from the CT signal.*
> *Step A4: Use the VT signal and the corrected CT signal to calculate the loop impedance as usual.*

The main difficulty here is to adjust the amplitude and phase of the digital signal in order to obtain the required level of compensation, and in particular to avoid overcompensation. This can be achieved conveniently by implementing the following algorithm:

*Compensation calibrating algorithm B*

> *Step B1: Introduce main loop to be measured with known impedance, eg. 1000 Ohms.*
> *Step B2: Calculate the loop impedance as usual. If the calculated value is sufficiently close to the ideal value (i.e. the known impedance of step B1) go to Step B4.*
> *Step B3: Adjust the amplitude and phase of the digital compensation signal and repeat Step B2.*
> *Step B4: Store the digital compensation signal for use in algorithm A.*

The digital compensation signal can be calculated in several ways rather than just with the algorithm B. One of the alternatives could be the following:

> Compensation calibration algorithm C
> *Step C1: Do not introduce any loop impedance (synonymous with open loop).*
> *Step C2: Calculate the loop impedance as usual. If the calculated value is sufficiently larger than the uppermost range of the device go to step C4.*
> *Step C3: Adjust the amplitude and phase of the digital compensation signal and repeat Step C2.*
> *Step C4: Store the digital compensation signal for use in algorithm A.*

It should be noted that an algorithm similar to the compensation calibration algorithm B can be used also for adjusting the auxiliary loop impedances 80 in the magnetic compensation and in the electric (signal) compensation techniques. This is especially relevant if the adjustment of impedance values of element 80 is carried out by means of digital control by signal processing unit 35. In such a case the algorithm could take a form:

> Compensation calibrating algorithm D
> *Step D1: Introduce main loop to be measured with known impedance,* eg. *1000 Ohms.*
> *Step D2: Calculate the loop impedance 62 as usual. If the calculated value is sufficiently close to the ideal value (i.e. the known impedance of step D1) go to Step D4.*
> *Step D3: Adjust the amplitude and phase of the digital compensation signal and repeat Step D2.*
> *Step D4: Use the value of auxiliary loop impedance 80 for use with the main algorithm A.*

As described in detail above, there are a number of embodiments and associated methods capable of compensating for interference. However, all these methods stem from the same concept - equation (iii) describes the effect of each and every embodiment described above.

There are a number of advantages associated with the application of these compensation techniques. In particular, by virtue of the fact that the compensation that is obtainable allows the shielding 42 used in current devices to be eliminated, a much simplified head design is allowed, which leads to reduced manufacturing costs. Moreover, this invention allows a substantial reduction in the size of the head, as well as increased accuracy of the device.

For example, currently used devices are not capable of detecting any values higher than 1550 Ohms, whereas the compensation techniques described above allow the upper limit to be extended to 5000 Ohms and above. The upper limit seems to be limited only by the resolution of the voltmeter or data acquisition device employed, rather than by the amount of interference, as it is the case for existing devices.

The significant improvement of accuracy for high values translates into noticeable improvement of accuracy in the medium range, and a lesser effect at the low measuring range. Any of the variations of the invention described above are capable of achieving the results shown in Fig. 13 - provided that sufficient control over stability and resolution of the appropriate component values is obtained.

It will be appreciated that the compensation methods can be used completely without shielding. However, they can also be applied to a design with limited electromagnetic shielding in order to improve the accuracy and immunity to interference still further whilst retaining the benefits of a less bulky head.

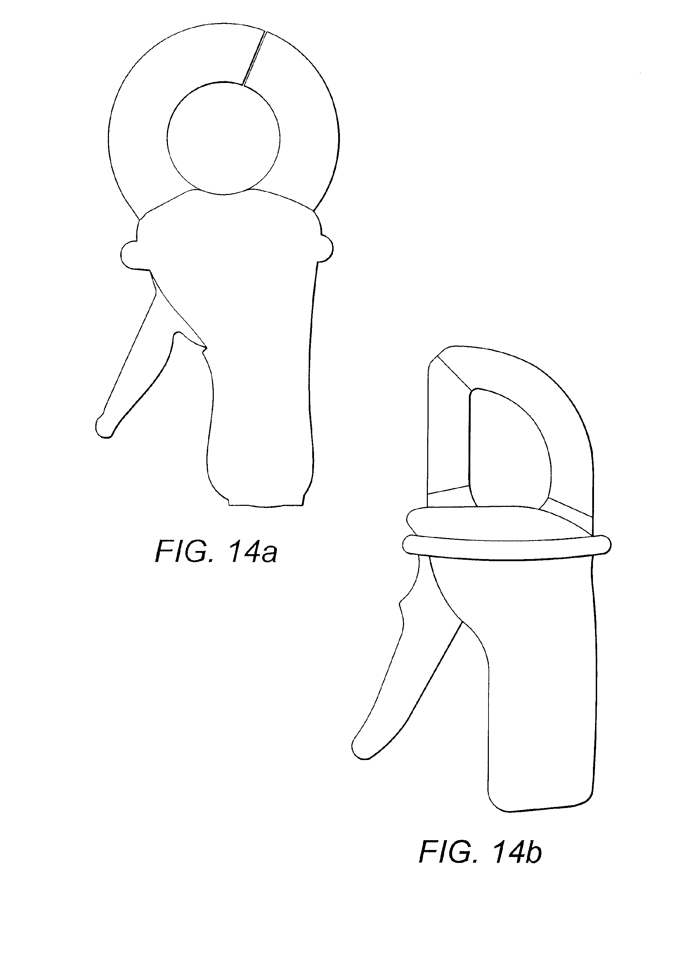

The cores 44, 46 described above are illustrated as being toroidal. It will be appreciated, however, that the shape of the cores is not significant and that many alternative shapes could be used. Fig. 14a is illustrative of a head portion of a double-clamp device having toroidal cores 44, 46. Fig. 14b is illustrative of an alternative double-clamp device, having differently-shaped cores.

## Claims

1. A double-clamp earth tester device comprising:

   a voltage-inducing transformer comprising a core and a primary winding having one or more turns around said voltage-inducing transformer core;
   a current-sensing transformer comprising a core and a secondary winding having one or more turns around said current-sensing transformer core, wherein the voltage-inducing transformer core and the current-sensing transformer core are adapted to be clamped around an earth electrode under test;
   a voltage source adapted to supply a voltage across the primary winding;
   a signal processing unit adapted to measure a resultant signal output from the secondary winding; and
   means to modify the signal output from the secondary winding so as to compensate for current induced by electromagnetic interference between the transformers.

2. The device of claim 1, wherein the means to modify the signal output from the secondary winding comprises magnetic compensation means which is adapted to generate a magnetic field in the current-sensing transformer core that is equal but opposite in magnitude to the portion of a magnetic field induced in the current-sensing transformer core by the electromagnetic interference between the transformers.

3. The device of claim 2, wherein the magnetic compensation means comprises an additional winding around the current-sensing transformer core and an associated additional signal source.

4. The device of claim 3, wherein the additional signal source is part of the signal processing unit.

5. The device of claim 2, wherein the magnetic compensation means comprises an auxiliary loop as a signal source around the voltage-inducing transformer core and the current-sensing transformer core.

6. The device of claim 5, wherein the electrode under test comprises part of an earthing system that can be represented by a loop of equivalent resistance and the auxiliary loop has reversed polarity with respect to the loop of equivalent resistance.

7. The device of claim 5 or claim 6, wherein the auxiliary loop contains a configurable impedance $Z_{aux}$.

8. The device of claim 1, wherein the means to modify the signal output from the secondary winding comprises electric compensation means which is adapted to generate a compensating signal that is equal but opposite in magnitude to the portion of the signal output from the secondary winding induced by the electromagnetic interference between the transformers.

9. The device of claim 8, wherein the electric compensation means comprises a signal source to supply the compensating signal to the secondary winding.

10. The device of claim 9, wherein the signal source comprises an auxiliary channel of the signal processing unit.

11. The device of claim 9, wherein the signal source is tapped from the primary winding.

**12.** The device of claim 9, wherein the signal source comprises a parasitic winding around the voltage-inducing transformer core.

**13.** The device of claim 12, wherein electrode under test may comprise part of an earthing system that can be represented by a loop of equivalent resistance and the parasitic winding has reversed polarity with respect to the loop of equivalent resistance.

**14.** The device of claim 12 or claim 13, wherein the parasitic winding contains a configurable impedance $Z_{aux}$.

**15.** The device of claim 8, wherein the electric compensation means comprises an analogue-to-digital converter for digitizing the signal output from the secondary winding, and means to apply an algorithm to the digitized signal.

**16.** The device of any preceding claim, wherein the voltage source comprises part of the signal processing unit.

**17.** The device of any preceding claim, wherein the voltage-inducing transformer core and the current-sensing transformer core are integrated into a head portion of the device.

FIG. 1a

FIG. 1b

FIG. 2a

FIG. 2b          FIG. 2c

FIG. 3

*FIG. 4*

FIG. 5

FIG. 6

**FIG. 7**

**FIG. 8**

FIG. 9

FIG. 10

FIG. 11a

FIG. 11b

FIG. 11c

FIG. 12

FIG. 13

FIG. 14a

FIG. 14b

**EUROPEAN SEARCH REPORT**

Application Number

EP 09 15 9431

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 396 284 B1 (TISDALE RALPH C [US] ET AL) 28 May 2002 (2002-05-28)<br>* figures 2,3,5 *<br>* column 1, line 5 - column 4, line 25 *<br>----- | 1-17 | INV.<br>G01R27/20<br>G01R31/02 |
| X | JP 61 288170 A (JAPAN ATOMIC ENERGY RES INST; NISSIN ELECTRIC CO LTD)<br>18 December 1986 (1986-12-18)<br>* figures 1,2 *<br>* abstract *<br>----- | 1-17 | |
| A | US 7 023 680 B1 (JOHNSON DAVID ALLAN [US] ET AL) 4 April 2006 (2006-04-04)<br>* figure 8 *<br>* column 8, line 50 - column 10, line 4 *<br>----- | 1 | |
| A | DE 701 471 C (ADOLF MATTHIAS DIPL ING)<br>17 January 1941 (1941-01-17)<br>* figure 1 *<br>* page 1, line 1 - page 2, line 103 *<br>----- | 1-17 | |
| A | US 4 857 830 A (MATSUNO TATSUJI [JP])<br>15 August 1989 (1989-08-15)<br>* figures 1-4,6,8(b),8(c) *<br>* column 1, line 6 - line 67 *<br>* column 4, line 4 - column 6, line 3 *<br>----- | 1-17 | TECHNICAL FIELDS SEARCHED (IPC)<br><br>G01R |
| A | US 4 851 761 A (MATSUNO TATSUJI [JP])<br>25 July 1989 (1989-07-25)<br>* figures 1,3(a)-3(c),7(a),7(b) *<br>* column 1, line 6 - line 67 *<br>* column 5, line 20 - line 35 *<br>-----<br>-/-- | 1-17 | |

The present search report has been drawn up for all claims

| Place of search | Date of completion of the search | Examiner |
|---|---|---|
| Berlin | 5 October 2009 | Höller, Helmut |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 09 15 9431

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2008/191705 A1 (BELLAN PAUL M [US]) 14 August 2008 (2008-08-14) * figures 1,3A,3B * * paragraph [0052] * * paragraph [0062] - paragraph [0066] * * paragraphs [0068], [0069], [0072] * * paragraphs [0073], [0078] *<br>----- | 1 | |
| A | "1625 Earth/Ground Tester User Manual" January 2006 (2006-01), FLUKE CORPORATION , XP002548781 Retrieved from the Internet: URL:http://assets.fluke.com/manuals/1625__ _umeng0000.pdf> [retrieved on 2009-10-02] * page 65 - page 71 *<br>----- | 1 | |
| | | | TECHNICAL FIELDS SEARCHED (IPC) |

The present search report has been drawn up for all claims

| Place of search | Date of completion of the search | Examiner |
|---|---|---|
| Berlin | 5 October 2009 | Höller, Helmut |

EPO FORM 1503 03.82 (P04C01)

**ANNEX TO THE EUROPEAN SEARCH REPORT
ON EUROPEAN PATENT APPLICATION NO.**

EP 09 15 9431

This annex lists the patent family members relating to the patent documents cited in the above-mentioned European search report.
The members are as contained in the European Patent Office EDP file on
The European Patent Office is in no way liable for these particulars which are merely given for the purpose of information.

05-10-2009

| Patent document cited in search report | | Publication date | Patent family member(s) | Publication date |
|---|---|---|---|---|
| US 6396284 | B1 | 28-05-2002 | NONE | |
| JP 61288170 | A | 18-12-1986 | NONE | |
| US 7023680 | B1 | 04-04-2006 | NONE | |
| DE 701471 | C | 17-01-1941 | NONE | |
| US 4857830 | A | 15-08-1989 | NONE | |
| US 4851761 | A | 25-07-1989 | NONE | |
| US 2008191705 | A1 | 14-08-2008 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7102360 B2